## Europäisches Patentamt

## European Patent Office

## Office européen des brevets

(19)

(11) Veröffentlichungsnummer: **0 106 154**
**B1**

(12) **EUROPÄISCHE PATENTSCHRIFT**

(45) Veröffentlichungstag der Patentschrift:
**07.12.88**

(51) Int. Cl.⁴: **H 01 J 37/147,** H 01 J 37/317

(21) Anmeldenummer: **83109001.4**

(22) Anmeldetag: **12.09.83**

(54) **Varioformstrahl-Ablenkobjektiv für Neutralteilchen und Verfahren zu seinem Betrieb.**

(30) Priorität: **22.09.82 DE 3235068**

(43) Veröffentlichungstag der Anmeldung:
**25.04.84 Patentblatt 84/17**

(45) Bekanntmachung des Hinweises auf die Patenterteilung:
**07.12.88 Patentblatt 88/49**

(84) Benannte Vertragsstaaten:
**DE FR GB NL**

(56) Entgegenhaltungen:
**GB-A- 2 055 243**
**US-A- 3 969 646**

**BULLETIN OF THE AMERICAN PHYSICAL SOCIETY,**
**Band 21, Nr. 9, Oktober 1976, Seite 1096, New York, US.**

(73) Patentinhaber: **Siemens Aktiengesellschaft Berlin und München, Wittelsbacherplatz 2, D-8000 München 2 (DE)**

(72) Erfinder: **Plies, Erich, Dr. rer. nat., Deisenhofener Strasse 79 c, D-8000 München 90 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Anordnung zur Ablenkung, Formung und Fokussierung eines Strahls aus Neutralteilchen mit magnetischem Dipolmoment nach dem Oberbegriff des Patentanspruchs 1 und ihre Verwendung.

Integrierte mikroelektronische Halbleiter-Bausteine und Halbleiter-Schaltkreise müssen strukturiert dotiert werden. Auch bei der Erzeugung sonstiger Mikrostrukturierungen müssen Teilchen in irgendwelche Objekte implantiert werden. Dies gilt z.B. für die Oberflächenveredelung, wo aufgrund von Rohstoffmangel und Rohstoffverteuerung nicht mehr die gesamte Oberfläche, sondern nur noch wesentliche Stellen veredelt werden, z.B. bei elektrischen Kontakten.

Bisher sind zur Dotierung von mikroelektronischen Bauelementen lithografische Verfahren mit Licht, Elektronen- und Röntgenstrahlen gebräuchlich. Die Lithographie mit Ionenstrahlen, bei der Muster von Masken auf Lack projiziert werden und bei der in Lack geschrieben wird, steckt noch in den Anfängen. Mit dem direkten Ionenstrahl-Implantationsschreiben in einen halbleiter-Wafer ist gerade erst in der Forschung begonnen worden (R.L. Seliger et al, J. Vac. Sci. Technol. 16, 1979, 1610 ff.), da erst neuerdings mit den Flüssigmetall-Ionenquellen (L.W. Swanson et al, J. Vac. Sci. Technol. 16, 1979, 18 64 ff.) geeignete Quellen mit hoher Intensität zur Verfügung stehen. Aufgrund der Coulomb-Wechselwirkung bei hohen Strahlströmen, die eine Energie- und Strahlverbreiterung bewirkt, können beim Elektronenstrahl- und Ionenstrahlschreiben bis heute jedoch nicht gleichzeitig hoher Durchsatz von erzeugten Strukturen und kleine Strukturgrösse der zu erzeugenden Strukturen, beispielsweise auf Halbleiterelementen, erreicht werden.

Der Erfindung liegt die Aufgabe zugrunde, eine Anordnung der eingangs genannten Art anzugeben, mit der gleichzeitig ein hoher Durchsatz von erzeugten Strukturen und eine kleine Strukturgrösse der zu erzeugenden Strukturen möglich sind.

Diese Aufgabe wird erfindungsgemäss durch eine Anordnung nach dem Anspruch 1 gelöst. Ausgestaltungen und Vorteile der Erfindung sind im Unteranspruch, der Beschreibung und der Zeichnung dargestellt.

Die Erfindung ermöglicht das «Neutralteilchen-Implantationsschreiben» als neue Methode zur Herstellung von integrierten mikroelektronischen Bausteinen. Da die meisten Implantationselemente im Grundzustand einen Drehimpuls der Elektronenhülle und damit ein magnetisches Dipolmoment besitzen, können sie durch Magnetfelder fokussiert und abgelenkt werden. Dies ermöglicht ein Neutralteilchen-Implantationsschreiben mit den Vorteilen:

a) Weniger Prozessschritte als bei lithografischen Verfahren,

b) die Wechselwirkung der Strahlteilchen untereinander ist wesentlich geringer als bei geladenen Teilchen, so dass eine Strahlverbreiterung bei hohen Strahlströmen aus diesem Grund nicht auftritt.

Die erfindungsgemässe Anordnung kann aus zwei bis vier magnetischen Sechs- oder Achtpollinsen bestehen, mit denen der Strahl nach Ausrichtung der magnetischen Dipole in zwei zueinander senkrechten Richtungen abgelenkt werden kann und fokussiert wird. Die Abbildung des Objektives als Ganzem ist stigmatisch und der Strahl wird geformt. Die Sondenformung ist fest bei Verwendung eines Dupletts von Sechs- bzw. Achtpollinsen und ist variabel in eine Richtung bei Verwendung eines Tripletts von Sechs- bzw. Achtpollinsen und ist variabel in zwei Richtungen bei Einsatz eines Quadrupletts von Sechs- bzw. Achtpollinsen. Da bei einer erfindungsgemässen Anordnung nur eine einzige Formstrahlblende notwendig ist, ergibt sich eine wesentlich bessere Strahlausnutzung als bei den in der Elektronenlithografie üblichen Methoden mit variabler Sonde, wo zwei Blenden durch Linsen oder durch Schattenabbildung aufeinander abgebildet werden.

In einer erfindungsgemässen Anordnung sind die Funktionen Abbildung, Ablenkung und variable Formung der Sonde in nur einem einzigen System aus einem Quadruplett von Sechs- oder Achtpollinsen vollständig integriert. Es genügt die Verwendung von Sechspollinsen, obwohl Achtpollinsen aus Justiergründen günstiger sind. Für eine erfindungsgemässe Anordnung kann eine Neutralteilchenquelle verwendet werden, die aus einer Flüssigmetall-Ionenquelle, wie sie beispielsweise in der obengenannten Veröffentlichung Swanson et al beschrieben ist, plus einem Neutralisator aufgebaut werden kann.

Die Erfindung wird im folgenden anhand von Ausführungsbeispielen unter Bezug auf die Zeichnung näher erläutert.

Fig. 1 zeigt eine magnetische Sechspollinse, die in einer erfindungsgemässe Anordnung Verwendung finden kann.

Fig. 2 zeigt eine magnetische Achtpollinse, die in einer erfindungsgemässen Anordnung Verwendung finden kann.

Fig. 3 zeigt den schematischen Aufbau einer erfindungsgemässen Anordnung.

Ein Strahl aus neutralen Atomen oder Molekülen mit dem magnetischen Dipolmoment $\vec{m}_D$ soll sich in Richtung der z-Achse eines kartesischen Koordinatensystems ausbreiten. Legt man nun ein homogenes Magnetfeld $\vec{H}$ in y-Richtung an, so wirkt auf jedes Strahlteilchen das Drehmoment

$$\vec{D} = \vec{m}_D \times \vec{H}. \tag{1}$$

Aus der Atomphysik ist bekannt, dass das magnetische Dipolmoment mit dem Drehimpuls der Elektronenhülle $\vec{J}$ gemäss

$$\vec{m}_D = -g_J \, \mu_B \, \vec{J} \, / \, \hbar \tag{2}$$

verknüpft ist und dass das Drehmoment $\vec{D}$ eine Präzession von $\vec{J}$ und $\vec{m}_D$ um die y-Richtung bewirkt. Die Präzessionsfrequenz dabei ist

$$\omega_p = m_D \, H \, / \, \vec{J} = g_J \, eB \, / \, (2 \cdot m_e). \tag{3}$$

In den Gleichungen (2) und (3) bedeuten: $\mu_B$ = Magneton; $\hbar$ = h/2$\pi$ mit h = Plancksches Wirkungsquantum; $m_e$ = Ruhemasse des Elektrons; $g_J$ = Landéscher g-Faktor.

Bei dieser Präzession bleibt nur die y-Komponente des Dipolmoments $\vec{m}_D$ zeitlich konstant. Diese y-Komponente des Dipolmoments $\vec{m}_D$ ist über

$$m_{Dy} = - M_J\, g_J\, \mu_B \qquad (4)$$

mit der magnetischen Quantenzahl $M_J$ verknüpft, wobei diese magnetische Quantenzahl $M_J$ insgesamt 2J + 1 Werte annehmen kann, wenn J die Gesamtdrehimpuls-Quantenzahl der Elektronenhülle ist. Damit die y-Komponente des Dipolmoments $m_{Dy}$ für alle Strahlteilchen gleich gross ist, müssen alle Strahlteilchen dieselbe magnetische Quantenzahl $M_J$ besitzen. Andere Quantenzustände sind mit einem Stern-Gerlach-Separator abzutrennen.

Sind die Teilchen so wie oben beschrieben ausgerichtet, so braucht man für die Stahlablenkung und Strahlfokussierung nur die zeitlich konstante Komponente $m_{Dy}$ des Dipolmoments zu berücksichtigen, da die Strahllaufzeit $\tau$ gross ist gegen die Präzessionsdauer $T_P$:

$$\tau = 1/v \gg 2\,\pi/\omega_P = 4\pi m_e\,/\,(g_J \cdot e \cdot B) = T_P, \qquad (5)$$

was man durch ein genügend grosses B-Feld erreicht. In der Gleichung (5) ist 1 die Strahllänge und v die Geschwindigkeit der Strahlteilchen.

Da auf magnetische Dipolteilchen im Magnetfeld $\vec{H}$ die Kraft

$$\vec{F} = (\vec{m}_D\,\overrightarrow{grad}\,\vec{H} = m_D\,\frac{d\vec{H}}{ds_{\vec{m}_D}} \qquad (6)$$

ausgeübt wird, muss das Magnetfeld $\vec{H}$ zur Ablenkung des Dipolteilchens in Richtung des magnetischen Dipolmoments $m_D$ einen Gradienten besitzen. Am einfachsten wird ein solcher Gradient konstant gewählt. Einen konstanten Feldgradienten besitzen aber gerade Quadrupolfelder der Gestalt

$$\psi = \psi_{2c}\,(z)\,(x^2 - y^2) + 2\psi_{2s}\,(z)\,x\,y\,,$$

$$\vec{B} = \mu_o\vec{H} = -\overrightarrow{grad}\,\psi = -2(\psi_{2c}x + \psi_{2s}y)\,\vec{e}_x +$$

$$2(\psi_{2c}y - \psi_{2s}x)\,\vec{e}_y \qquad (7)$$

In Gleichung (7) ist $\psi$ das skalare magnetische Potential, und $\psi_{2c}(z)$ und $\psi_{2s}(z)$ sind Feldkoeffizienten, die nicht von x bzw. y abhängig sind.
Mit dem Magnetfeld $\vec{H}$ aus Gleichung (7) und dem magnetischen Moment $\vec{m}_D = m_{Dy}\,\vec{e}_y$ liefert Gleichung (6) die Kraft $\vec{F}$:

$$\vec{F} = (m_{Dy}\,\vec{e}_y\,\overrightarrow{grad})\,\vec{H} = m_{Dy}\,\frac{\vartheta\vec{H}}{\vartheta y}$$

$$= \frac{2m_{Dy}}{\mu_o}\left\{-\psi_{2s}\,\vec{e}_x + \psi_{2c}\,\vec{e}_y\right\} \qquad (8)$$

Das Quadrupolfeld $\vec{B}$ nach Gleichung (7) bewirkt eine Ablenkung von Neutralteilchen, welche das magnetische Moment $\vec{m}_D = m_{Dy}\,\vec{e}_y$ aufweisen, sowohl in y-Richtung als auch in x-Richtung. Durch Überlagerung des Quadrupolfeldes, welches eine Ablenkung in x-Richtung bewirkt, und des Quadrupolfeldes, welches eine Ablenkung in y-Richtung bewirkt, kann eine Ablenkung der Neutralteilchen, die im wesentlichen nur eine y-Komponente des magnetischen Dipolmoments aufweisen, in eine beliebige Richtung vollzogen werden. Die Ablenkrichtung mit dem Winkel der Ablenkrichtung $\vartheta_A$ ist durch das Verhältnis der Feldkoeffizienten $\psi_{2c}/\psi_{2s}$ aus Gleichung (7) bestimmt:

$$\vartheta_A = \arctan\left(\frac{y_A}{x_A}\right) = \arctan\frac{\psi_{2c}}{\psi_{2s}}\,. \qquad (9)$$

Der Betrag der Ablenkkoordinate

$$r_A = \sqrt{x_A{}^2 + y_A{}^2}$$

ist proportional zu

$$\sqrt{\psi_{2c}{}^2 + \psi_{2s}{}^2}\,.$$

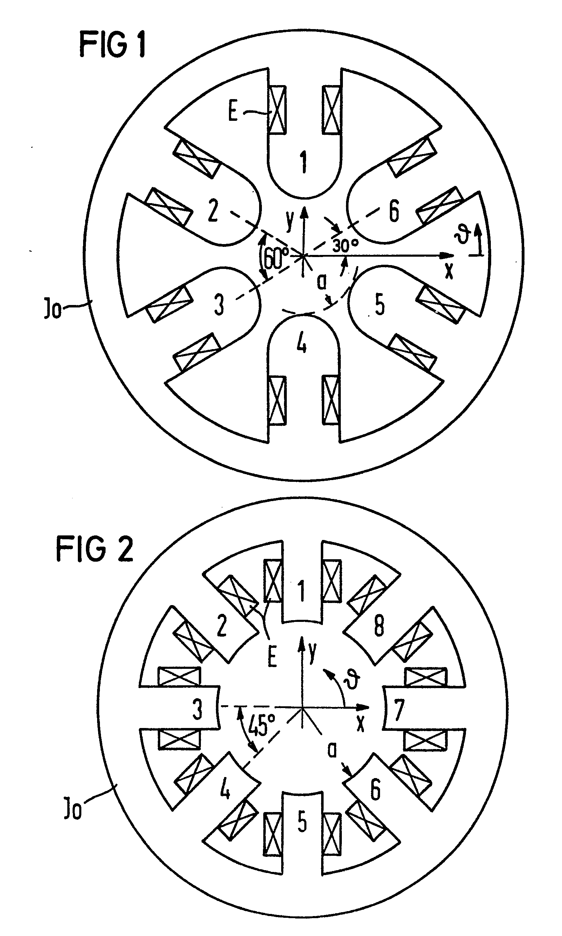

Bei der Beschreibung der Fig. 1 und 2 ist angegeben, wie mit einer magnetischen Sechspollinse bzw. einer magnetischen Achtpollinse ein azimutal drehbares und in der Stärke variierbares Quadrupolfeld erzeugt werden kann.

Dem Fachmann ist bekannt, dass Neutralteilchen, welche ein magnetisches Dipolmoment aufweisen, mittels Hexapolmagneten (Sextupolmagneten) fokussiert werden können. Allerdings ist diese Fokussierung nur in einem Schnitt konvergent und im anderen Schnitt divergent, d.h. defokussierend.

Da die magnetischen Dipolmomente der Strahlteilchen bei dem hier besprochenen Ausführungsbeispiel durch ein äusseres Magnetfeld $\vec{H}$ in y-Richtung ausgerichtet sind, muss das Hexapolfeld zur Fokussierung der Strahlteilchen die Form:

$$\vec{B} = -\psi_{3s}\,\{2 \times y\,\vec{e}_x + (x^2 - y^2)\vec{e}_y\} \qquad (10)$$

haben, dem das skalare magnetische Potential

$$\psi = \Psi_{3s}\,(3\,x^2\,y - y^3) \qquad (11)$$

zugeordnet ist. Mit der Gleichung (10) ergibt sich dann die Bewegungsgleichung:

$$m\left(\frac{d^2x}{dt^2}\,\vec{e}_x + \frac{d^2y}{dt^2}\,\vec{e}_y\right) = m_{Dy}\,\frac{\delta\vec{H}}{\delta y}$$

$$= -6\,\frac{m_{Dy}\psi_{3s}}{\mu_o}\,(x\,\vec{e}_x - y\,\vec{e}_y) \qquad (12)$$

In Gleichung (12) bezeichnet m die Masse des Neutralteilchens und t kennzeichnet die Zeit. Eliminiert man aus Gleichung (12) die Zeit t mittels

$$\frac{d}{dt} = \frac{dz}{dt}\,\frac{d}{dz} \approx v\,\frac{d}{dz},$$

wobei v die Teilchengeschwindigkeit bedeutet, so erhält man die beiden Bahngleichungen:

$$\frac{d^2x}{dz^2} + k\,x = 0,$$
$$\frac{d^2y}{dz^2} - k\,y = 0, \qquad (13)$$
$$\text{mit } k = 6\,\frac{m_{Dy}\Psi_{3s}}{m\mu_o v^2}\ .$$

Aus den Gleichungen (13) entnimmt man erstens dass gilt: Ist der Koeffizient $\Psi_{3s}$ grösser als Null, so ergibt sich eine Fokussierung im x-Schnitt und eine Defokussierung im y-Schnitt; ist der Koeffizient $\Psi_{3s}$ jedoch kleiner als Null, so ergibt sich umgekehrt eine Defokussierung im x-Schnitt und eine Fokussierung im y-Schnitt.

Zweitens ersieht man aus der Gleichung (13), dass diese paraxialen Bahngleichungen für ein Neutralteilchen, welches ein magnetisches Dipolmoment aufweist, in einem Hexapolfeld dieselbe Gestalt besitzen wie die paraxialen Bahngleichungen eines geladenen Teilchens in einem Quadrupolfeld. Die paraxialen Bahngleichungen eines geladenen Teilchens in einem Quadrupolfeld sind aus dem Buch von P. W. Hawkes, Quadrupoles in Electron Lens Design, Academic Press (1970) beschrieben. Dies bedeutet insbesondere, dass alle aus dieser Quadrupoloptik bekannten Gesetze voll auf die Fokussierung von Neutralteilchen mit unserem Ausführungsbeispiel übertragen werden können.

Mit einem Duplett aus Hexapolmagneten, von denen der eine Hexapolmagnet einen Koeffizienten $\Psi_{3s}>0$ hat und von denen der andere Hexapolmagnet einen Koeffizienten $\Psi_{3s}<0$ aufweist, kann eine stigmatische Abbildung mit Neutralteilchen erreicht werden. Allerdings sind dann die beiden Hauptvergrösserungen $V_x$ und $V_y$ nicht mehr variierbar, ohne dass man Gegenstandsweite, Bildweite oder den Abstand der Duplett-Hexapollinsen ändert.

Verwendet man ein Triplett von Hexapollinsen, so kann man stigmatische Abbildung erreichen und durch Ändern der Hexapolstärken den Quotienten $V_y/V_x$ der beiden Hauptvergrösserungen in gewissen Grenzen variieren und gleichzeitig die stigmatische Bildebene festhalten. Bei Verwendung eines Quadrupletts von Hexapollinsen ist es sogar möglich, die beiden Hauptvergrösserungen $V_y$ und $V_x$ in gewissen Grenzen getrennt zu ändern, ohne dass die stigmatische Abbildung für die feste Bildebene verlorengeht.

Eine Abschätzung der magnetischen Induktion B, die für die Ausrichtung des Neutralteilchenstrahls notwendig ist, ergibt:

$$B \gg \frac{4\pi}{g_J}\frac{m_e}{el}\cdot\sqrt{\frac{2eU_B}{m}} \qquad (14)$$

Dabei ist $U_B$ die kinetische Energie des Neutralteilchens in Volt und m seine Masse. Für Arsen mit einem Atomgewicht von 74,9 und einem Landé-Faktor $g_J = 2$ (wegen Grundzustand $^4S_{3/2}$), einer Strahllänge $1 = 0{,}2$ m und der Spannung $U_B = 2$ kV erhält man die leicht zu erfüllende Forderung, dass die magnetische Induktion B wesentlich grösser als 0,13 Gauss sein muss.

Eine Abschätzung der maximal möglichen Strahlablenkung bei Vernachlässigung des Randfeldes ergibt für die Ablenkung $y_A$ nach elementarer Rechnung:

$$|y_A| = |M_J|g_J\ \mu_B\ \frac{\hat{\Psi}_{2c}1}{\mu_o E_{kin}}\ (1/2 + L). \qquad (15)$$

Dabei ist mit 1 die Wegstrecke bezeichnet, auf der die magnetische Induktion B auf die Neutralteilchen einwirkt, und mit L ist die Wegstrecke bezeichnet, die die Neutralteilchen nach Einwirkung der magnetischen Funktion noch bis zu dem Ort zurücklegen, an dem die Ablenkung $y_A$ gemessen wird. $\Psi_{2c}$ sei dabei der Quadrupol-Koeffizient eines Magnetfeldes B mit $\vec{B} = 2\vec{\Psi}_{2c}\{-x\vec{e}_x + y\,\vec{e}_y\}$.

Wird für die Randfeldstärke an den Polschuhen der magnetischen Linse ein Wert von 20 k Gauss angenommen, für die kinetische Energie der Neutralteilchen ein Wert von 2 kV, für den Abstand der Polschuhe der magnetischen Linse ein Wert von 4 mm, für die Wegstrecke der Neutralteilchen im Wirkungsbereich der magnetischen Induktion ein Wert von 200 mm und für die freie Wegstrecke nach Einwirkung dieser magnetischen Induktion bis zur z-Koordinate derjenigen Ebene, in der die Ablenkung $y_A$ gemessen wird, ein Wert von 500 mm, wenn man weiter für die magnetische Quantenzahl $M_J$ einen Wert von 3/2 und für den Landé-Faktor $g_J$ einen Wert von 2 annimmt, dann erhält man eine Ablenkung $|y_A|$ von etwa 5 μm. Dies bedeutet für die Praxis, dass man wegen des kleinen Rasterfeldes der erfindungsgemässen Anordnung zusätzlich einen lasergesteuerten, mechanisch bewegbaren Objekttisch benötigt.

Fig. 1 zeigt eine magnetische Sechspollinse, die in einer erfindungsgemässen Anordnung verwendet werden kann. Diese magnetische Sechspollinse befindet sich in der x-y-Ebene, weist ein Joch JO und sechs Polschuhe 1 bis 6 mit Erregerwicklungen E auf. In den Erregerwicklungen E der einzelnen Polschuhe fliessen dabei folgende Ströme:

Im Polschuh 1: $I_{1s} - I_{2c} - I_{3s}$

Im Polschuh 2: $\dfrac{I_{1s}}{2} + \dfrac{I_{2c}}{2} - \dfrac{\sqrt{3}}{2}I_{2s} + I_{3s}$

Im Polschuh 3: $-\dfrac{I_{1s}}{2} + \dfrac{I_{2c}}{2} + \dfrac{\sqrt{3}}{2}I_{2s} - I_{3s}$

Im Polschuh 4: $-I_{1s} - I_{2c} + I_{3s}$

Im Polschuh 5: $-\dfrac{I_{1s}}{2} + \dfrac{I_{2c}}{2} - \dfrac{\sqrt{3}}{2}I_{2s} - I_{3s}$

Im Polschuh 6: $\dfrac{I_{1s}}{2} + \dfrac{I_{2c}}{2} + \dfrac{\sqrt{3}}{2}I_{2s} + I_{3s}$

Mit a ist der halbe Abstand zwischen den Polschuhen 1 bis 6 bezeichnet. Der Ablenkwinkel $\vartheta$ wird von der positiven x-Halbachse zur positiven y-Halbachse hin gezählt. Die Spulenströme sind zu den Koeffizienten des skalaren magnetischen Potentials proportional, und zwar sind die Spulenströme mit einem Index i jeweils proportional dem Koeffizienten $\Psi$ mit demselben Index i. Das skalare magnetische Potential $\psi$ ist dann von folgender Form:

$$\psi = \Psi_{1s}r\sin\vartheta + \Psi_{2c}r^2\cos2\vartheta + \Psi_{2s}r^2\sin2\vartheta + \Psi_{3s}r^3\text{-}\sin3\vartheta$$
$$= \Psi_{1s}y + \Psi_{2c}(x^2-y^2) + 2\Psi_{2s}xy + \Psi_{3s}(3x^2y - y^3) \tag{16}$$

Die magnetische Induktion und das magnetische Feld einer magnetischen Sechspollinse nach Fig. 1 setzen sich bei unserem Ausführungsbeispiel aus drei Termen zusammen, und zwar aus einem Dipolfeld in y-Richtung zur Ausrichtung der Strahlteilchen, einem in Stärke und Azimutlage variierbaren Quadrupolfeld zur Strahlablenkung und einem azimutal festen Hexapolfed zur Strahlfokussierung, wie dies weiter oben abgeleitet und angegeben worden ist:

$$\vec{B} = \mu_0\vec{H} = -\psi_{1s}\,\vec{e}_y - 2\big\} \,(\psi_{2c}\,x + \psi_{2s}y)\,\vec{e}_x + \big\}$$
$$(\psi_{2s}x - \psi_{2c}y)\,\vec{e}_y\big\} \quad -3\psi_{3s}\,\big\{2\,x\,y\,\vec{e}_x +$$
$$(x^2 - y^2)\,\vec{e}_y\big\} \tag{17}$$

Fig. 2 zeigt eine magnetische Achtpollinse, wie sie in einer erfindungsgemässen Anordnung verwendet werden kann. Eine magnetische Achtpollinse nach Fig. 2 befindet sich wiederum in einer x-y-Ebene, weist wiederum ein Joch JO auf und acht Polschuhe 1 bis 8, die jeweils eine Erregerwicklung E besitzen. In den Erregerwicklungen E der Polschuhe 1 bis 8 fliessen folgende Spulenströme:

Beim Polschuh 1: $I_{1s} - I_{2c} - I_{3s}$

Beim Polschuh 2: $\dfrac{I_{1s}}{\sqrt{2}} - I_{2s} + \dfrac{I_{3s}}{\sqrt{2}}$

Beim Polschuh 3: $I_{2c}$

Beim Polschuh 4: $-\dfrac{I_{1s}}{\sqrt{2}} + I_{2s} - \dfrac{I_{3s}}{\sqrt{2}}$

Beim Polschuh 5: $-I_{1s} - I_{2c} + I_{3s}$

Beim Polschuh 6: $-\dfrac{I_{1s}}{\sqrt{2}} - I_{2s} - \dfrac{I_{3s}}{\sqrt{2}}$

Beim Polschuh 7: $I_{2c}$

Beim Polschuh 8: $\dfrac{I_{1s}}{\sqrt{2}} + I_{2s} + \dfrac{I_{3s}}{\sqrt{2}}$

Diese Spulenströme $I_i$ nach Fig. 2 haben dieselbe Beziehung zum skalaren magnetischen Potential und zur magnetischen Induktion und zum magnetischen Feld wie die entsprechenden Spulenströme in Fig. 1.

Die zu $I_{1s}$ proportionalen Teilströme bewirken ein Dipolfeld in y-Richtung zur Ausrichtung des magnetischen Dipolmoments der Strahlteilchen.

Die zu $I_{2c}$ oder $I_{2s}$ proportionalen Teilströme bewirken ein in Stärke und Azimutlage verstellbares Quadrupolfeld zur Ablenkung des Atomstrahls in x- und y-Richtung.

Die zu $I_{3s}$ proportionalen Teilströme bewirken ein in der Azimutlage festes Hexapolfeld, womit der Teilchenstrahl in dem einen Schnitt fokussiert und im anderen Schnitt defokussiert werden kann.

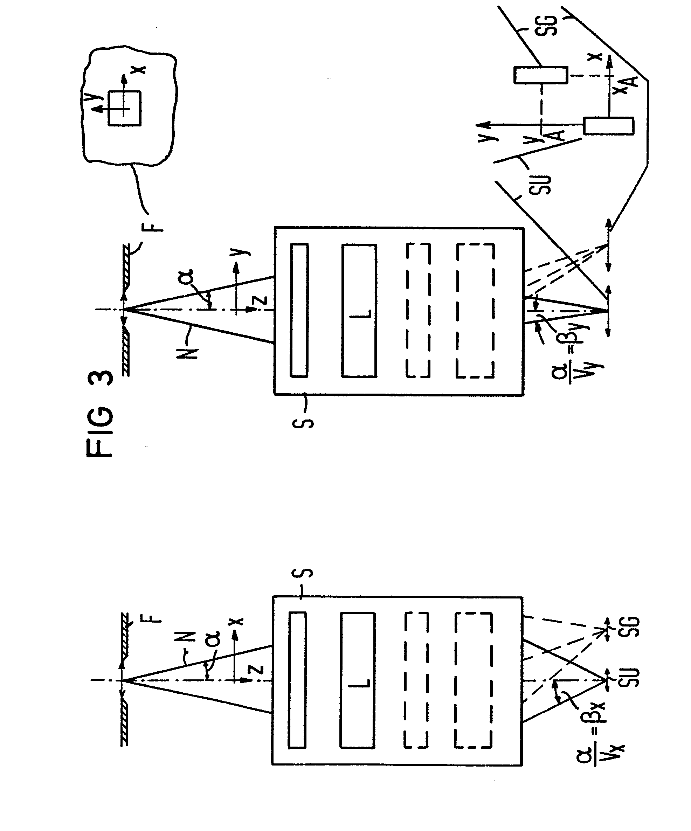

Der Aufbau einer erfindungsgemässen Anordnung ist schematisch in Fig. 3 dargestellt, deren linker Teil einen Schnitt in der x-z-Ebene und deren rechter Teil einen Schnitt in der y-z-Ebene zeigt. Ein Neutralteilchenstrahl N durchläuft eine Formstrahl-Blende F und weitet sich dabei in z-Richtung kegelförmig mit einem Winkel $\alpha$ auf. Dieser Neutralteilchenstrahl N durchläuft sodann ein System aus zwei, drei oder vier Sechspol- bzw. Achtpollinsen L, wie sie in Fig. 1 bzw. Fig. 2 angegeben sind. Die unabgelenkte, geformte Teilchenstrahl-Sonde SU wird kegelförmig auf ein Objekt fokussiert. Die Winkel dieser Kegel sind $\beta_x$ bzw. $\beta_y$. Damit ergeben sich die beiden Hauptvergrösserungen zu $V_x = \alpha/\beta_x$ und $V_y = \alpha/\beta_y$. Die abgelenkte, geformte Teilchenstrahl-Sonde SG kann erfindungsgemäss beliebige Ablenkkoordinaten $x_A$, $y_A$ aufweisen.

**Patentansprüche**

1. Anordnung zur Ablenkung, Formung und Fokussierung eines Strahls aus Neutralteilchen mit magnetischem Dipolmoment, gekennzeichnet durch eine Formblende (F) und zwei bis vier magnetische Sechs- oder Achtpollinsen.

2. Anordnung nach Anspruch 1, gekennzeichnet durch eine einzige Formblende (F).

3. Verwendung einer Anordnung nach Anspruch 1 oder 2 zur Herstellung elektronischer Bauelemente.

4. Verwendung einer Anordnung nach Anspruch 1 oder 2, zur Erzeugung von Strukturen in einem Objekt.

**Claims**

1. An arrangement for deflecting, shaping and focussing a beam of neutral particles having a magnetic dipole moment, characterised by a diaphragm (F) and two to four magnetic six-pole or eight-pole lenses.

2. An arrangement as claimed in Claim 1, characterised by one single diaphragm (F).

3. Use of an arrangement as claimed in Claim 1 or 2 for the production of electronic components.

4. Use of an arrangement as claimed in Claim 1 or 2 for the production of structures in an object.

**Revendications**

1. Dispositif pour dévier, mettre en forme et focaliser un faisceau formé de particules neutres possédant un moment dipolaire magnétique, caractérisé par un diaphragme (F) de mise en forme et deux à quatre lentilles magnétiques à six ou à huit pôles.

2. Dispositif suivant la revendication 1, caractérisé par un seul diaphragme (F) de mise en forme.

3. Application d'un dispositif selon la revendication 1 ou 2, à la fabrication de composants électroniques.

4. Application d'un dispositif selon la revendication 1 ou 2 à la fabrication de structures dans un objet.

# FIG 1

# FIG 2

FIG 3

$\frac{\alpha}{V_x} = \beta_x$

$\frac{\alpha}{V_y} = \beta_y$

EP 0 106 154 B1